Europäisches Patentamt

European Patent Office

Office européen des brevets

(19)

(11) **EP 0 473 139 B1**

(12) EUROPEAN PATENT SPECIFICATION

(45) Date of publication and mention
of the grant of the patent:
**09.06.1999 Bulletin 1999/23**

(51) Int Cl.[6]: **G06F 12/06**

(21) Application number: **91114455.8**

(22) Date of filing: **28.08.1991**

(54) **Memory decoding system for a portable data terminal**

Speicherdekodierungssystem für eine tragbare Datenendstation

Système de décodage de mémoire pour un terminal de données portable

(84) Designated Contracting States:
**DE GB NL**

(30) Priority: **30.08.1990 KR 1316990**

(43) Date of publication of application:
**04.03.1992 Bulletin 1992/10**

(73) Proprietor: **GOLD STAR CO. LTD**
**Seoul (KR)**

(72) Inventor: **Moon, Sung Won**
**Songpa-ku Seoul (KR)**

(74) Representative: **VOSSIUS & PARTNER**
**Postfach 86 07 67**
**81634 München (DE)**

(56) References cited:
**EP-A- 0 394 935**

- **ELEKTOR, vol. 9, no. 3, March 1983,**
  **CANTERBURY, GB; pages 28 - 35; 'Universal**
  **Memory Card'**
- **PATENT ABSTRACTS OF JAPAN vol. 5, no. 130**
  **(P-076)20 August 1981 & JP-A-56 068 988**
  **( TOSHIBA ) 9 June 1981**
- **REVIEW OF SCIENTIFIC INSTRUMENTS, vol. 55,**
  **no. 12, December 1984, NEW YORK, US; pages**
  **2017 - 2022; B. H. NEWCOME ET AL: 'Modular**
  **Twin Bus Microprocessor System for Laboratory**
  **Automation'**

## Description

The present invention relates to a memory decoding system, and particularly to a memory decoding system for use on a portable data terminal.

A portable data terminal is restricted in its board size, and therefore, all the circuits of it have to be simplified as far as possible.

Further, as a dc power source is used, the number of the component circuits has to be reduced to the minimum in order to prevent the unnecessary consumption of power. The memory decoding system of a portable data terminal includes : a separate ROM as the main memory device ; and a plurality of RAMs together with a microprocessor.

These components are provided in such a manner that they should form an internal main device, internal and external peripheral devices, and a data terminal.

The ROM is primarily used to store the system program, and the plurality of the RAMs are used for carrying out jobs and for operating the programs. Therefore, if the ROM and RAM are separately assigned with addresses in using them, the system program becomes complicated, and can lower the processing performance of the microprocessor owing to the inherent characteristics of the portable data terminal. Therefore it is required that the ROM and RAM be assigned with addresses in an integrated form.

Generally, the memory decoding system for the portable data terminal use customized chips as in ASIC, and therefore, its constitution and operating principle can not be known.

The memory decoding system for a portable data terminal shown in the drawing of circuit No. 75 which is disclosed under 2.2.16 in the technical reference manual for Model-20 which is a product of Norland Company of England includes large numbers of gates and logic ICs, and therefore difficulties are encountered in forming the product into a compact type.

In the memory decoding system as shown in said drawing, the memory banks can be subjected to 3 switchings by means of the system program, and the ROM and the RAM can be interconnected in 32 bits. Such things can be known from said drawing, but no more exact operating principles can be known.

In forming the memory section as the main memory device for the portable data terminal, if the ROM and the RAM are assigned with independent addresses as in the usual cases, the program for operating them becomes complicated, and as a result, the processing capability of the microprocessor is lowered.

Further, due to the restriction in the board size, all the circuits have to be designed in compact types. Further, the number of chips used has to be reduced as far as possible.

Patent Abstracts of Japan, Vol. 5, no. 130 (P-076), August 20, 1981 relates to a semiconductor memory wherein the memory is subdivided into separate regions and the higher bits of the address signal are analyzed in order to select one of these regions. The selected region is activated and the other regions are set to a power-down state.

The present invention is intended to overcome the above described disadvantages of the conventional technique.

Therefore it is the object of the present invention to provide a memory decoding system which can be used in a portable data terminal in a convenient manner by mapping the memory in such a manner that the RAMs and the ROM forming the memory section are assigned with addresses in an integral form.

In achieving the above object, the system of the present invention preferably includes:

a microprocessor for generating address signals having the required bit number, data signals having the required bit number, memory request signals, and memory read/write signals ;

a memory section consisting of a ROM and a plurality of RAMs, having an address map consisting of a system ROM region, a reserve region,

a user RAM region, and a system RAM region in an integral form for the whole system, and connected through a common bus (for address and data) to the microprocessor ;

an OR gate for OR-computing the uppermost two address signals ;

a RAM selection signal generating section for outputting a certain number of RAM selecting signals after receipt of a certain number of the uppermost address signals (excluding the uppermost two addresses), and using the output signals of the OR gate, the memory request signals, and the power-on driving voltage as the enabling signals ;

a NAND gate section for receiving a certain number of the uppermost address signals (including the uppermost two addresses inputted into the OR gate computing section) ; and

a ROM selection signal generating section having an OR gate for OR-computing the output signals of the NAND gate and the memory request signals, and for outputting the computed signals as the ROM selecting signals.

The above object and other advantages of the present invention will become more apparent by describing in detail the preferred embodiment of the present invention with reference to the attached drawings in which :

Figure 1 is a block diagram showing the constitution of the usual portable data terminal ;
Figure 2 illustrates the constitution of the memory address map according to the present invention ; and
Figure 3 illustrates the circuit of the memory decoding system of the portable data terminal according to the present invention.

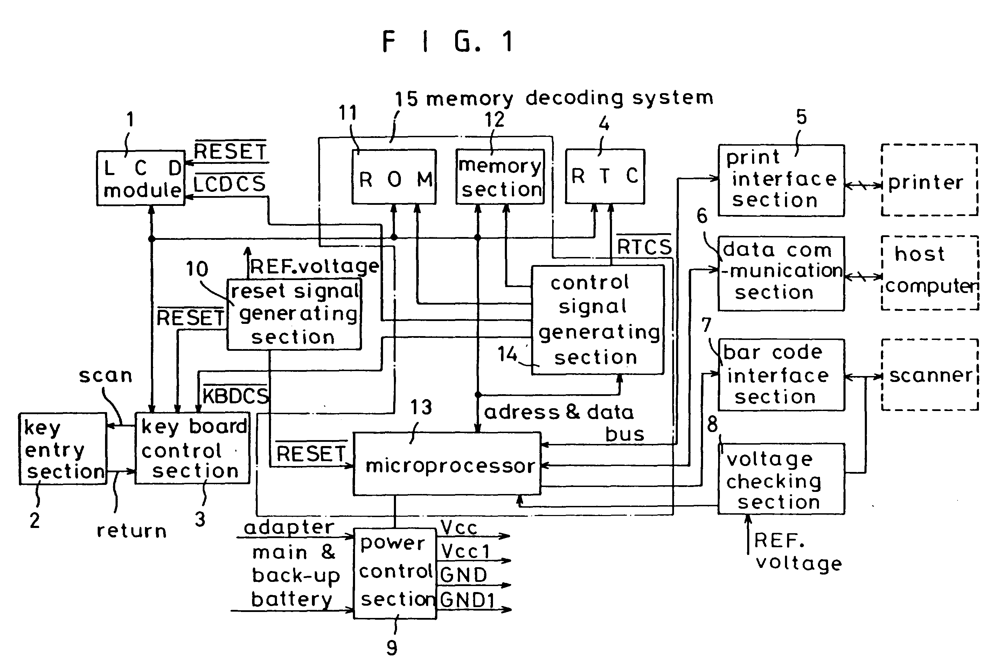

The preferred embodiment of the present invention will be described referring to Figures 1 to 3.

Figure 1 is a block diagram showing the constitution of the usual portable data terminal, and this is for helping the understanding on the apparatus of the present invention.

As shown in this drawing, the data terminal includes :

an LCD (liquid crystal display) module 1 for displaying characters and graphs after receipt of data based on the system program; a key entry section 2 consisting of a plurality of letter keys and numeral keys ;

a key board control section 3 for scanning and decoding the key state of the entry section 2 in order to send the letter and numeral key signals from the key entry section to the LCD module 1 ;

an RTC section (real time clock section) 4 for generating the time required in the portable data terminal, and capable of showing year, month and date, and leap year automatically ;

a print interface section 5 for sending the data to be printed to a separate external printer ; a data communication section 6 (e.g. RS-232 or uPD-4711) for connecting the data (to be transmitted and received) to an external host computer in series ; a bar code interface section 7 for inputting bar codes (consisting of black and white bars) through a separate scanner ; a voltage checking section 8 for displaying a low voltage state upon finding the voltage to be lower than a reference voltage by checking the state of a battery used as the driving power source for the portable data terminal ; a power control section 9 for supplying the power source of an adaptor to the respective sections of the memory decoding system, the adaptor being for converting the powers of a main battery, a back-up battery and an external ac power source to a dc power ; a reset signal generating section 10 for supplying reset signals to the microprocessor key board control section 3 and to the LCD module 1 in accordance with the selections by the user ; a ROM 11 for storing the system program ; a memory section 12 conmsisting of a plurality of RAMs for operating the user's program ; a microprocessor 13 for controlling the system operations by using the system program stored in the ROM 11 ; and a control signal generating section 14 connected through an address/data but to the microprocessor 13, and for generating various control and memory selection signals in order to operate the system after receipt of address signals from the microprocessor 13.

In order to prevent the squandering of the power for purposes other than the above described functions, the power control section 9 is automatically turned off if the system is kept unused for a predetermined period of time.

The ROM 11, the memory section 12, the microprocessor 13 and the control signal generating section 14 are in all called by the general name of memory decoding system 15.

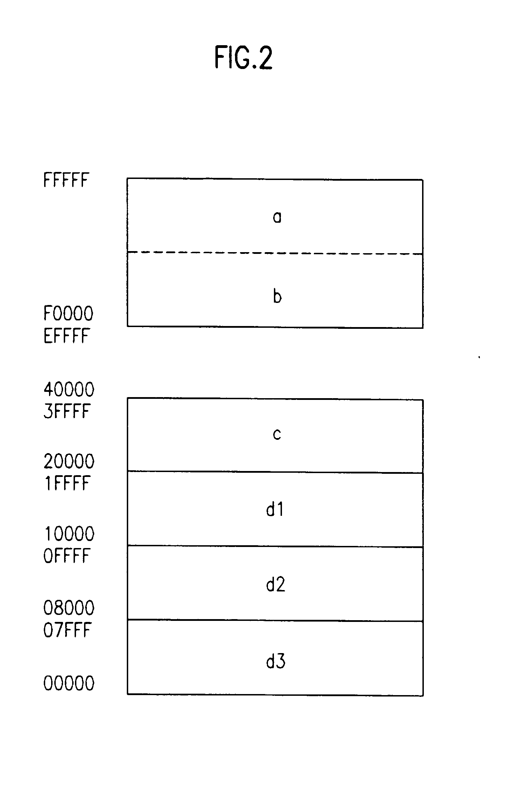

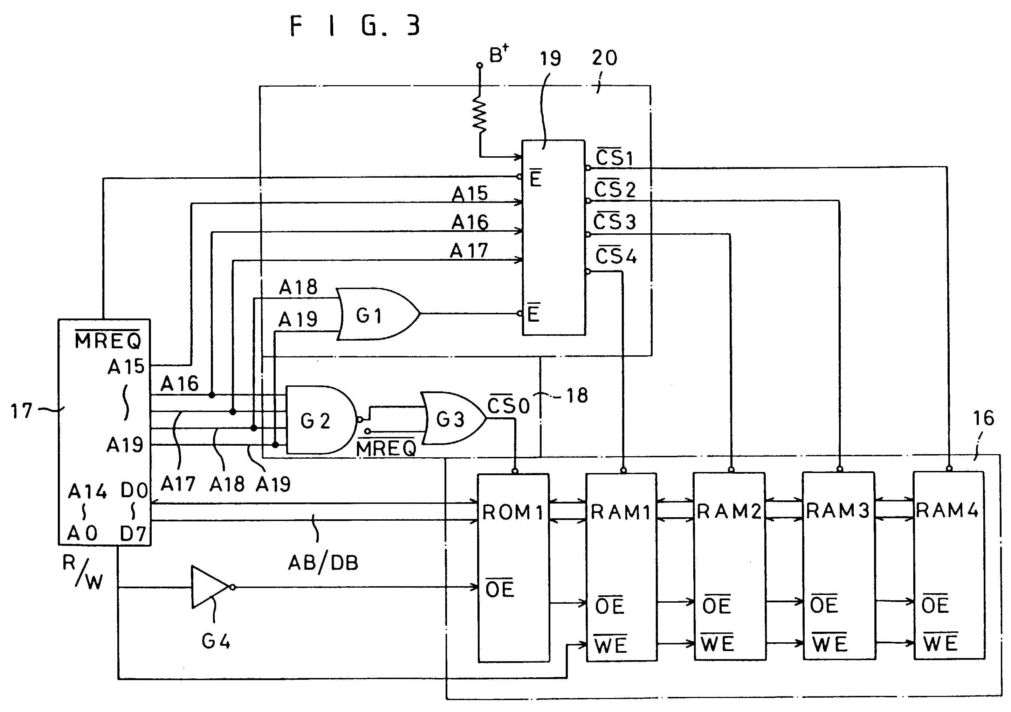

According to the present invention, the memory decoding system 15 is properly adapted to the portable data terminal with the minimum number of chips, and the preferred embodiment of the present invention based on this principle will be illustrated in Figure 2 and 3.

Figure 2 illustrates the address map structure of the ROM 11 and the memory section consisting of a plurality of RAMs according to the present invention. The total addresses which can be designated by the microprocessor 13 are made to consist of $00000_{16}$ through $FFFFF_{16}$ with the number system of 16s progress according to the present embodiment. Further, the total addresses are divided into a system ROM region a, a reserve ROM region b, a system RAM region c and user regions $d_1$ -$d_3$.

Figure 3 illustrates the memory decoding system of the portable data terminal employing the memory address map of Figure 2. As shown in this drawing, the memory decoding system includes : a memory section 16 consisting of a $ROM_1$ (64 Kbit is used in the present invention) having the addresses of the system ROM region a and the reserve ROM region b, and 4 RAMs ($RAM_1$ -$RAM_4$) (32 Kbit SRAMs are used in the present invention) having the addresses of the system RAM region c and the user RAM regions $d_1$ -$d_3$ ; a microprocessor 17 (V25 of NEC is used in the present invention) for generating internal 16-bit and external 8-bit signals containing address signals $A_0$-$A_{19}$, memory request signals MREQ, 8 data ($D_0$-$D_7$) and memory read/write signals R/W ; a first selection signal generating section 18 consisting of a NAND gate $G_2$ receiving the four uppermost address signals $A_{16}$ - $A_{19}$ of the address signals outputted from the microprocessor 17, and an OR gate $G_3$ receiving the output signals of the NAND gate $G_2$ and the memory request signals MREQ of the microprocessor 17, and for outputting the output signals of the OR gate $G_3$ to the $ROM_1$ of the memory section 16 in the form of chip selecting signals $\overline{CS_0}$ ; and a second selection signal generating section 20 consisting of an OR gate $G_1$ and a decoder 19, with the OR gate $G_1$ being for receiving the uppermost two address signals $A_{18}$ - $A_{19}$ together with the NAND gate $G_2$, and with the decoder 19 being for receiving the three upper address signals $A_{15}$- $A_{17}$ , for using, as the enabling signals CE, the memory request signals MREQ, the output signals of the OR gate $G_1$ and the system turning-on driving voltage $B^+$, and for generating chip selecting signals $\overline{CS}_1$ - $\overline{CS}_4$ for the 4 RAMs $RAM_1$ -$RAM_4$ of the memory section 16. Further, the microprocessor 17 is connected to the memory section 16 in such a manner that the memory read/write signals R/W should be supplied as write enabling signals WE to the $ROM_1$ and RAMs $RAM_1$ -$RAM_4$ of the memory section 16, and that the memory read/write signals R/W should be supplied through an inverting device $G_4$ as an output enabling signal OE. The apparatus of the present invention constituted as above will now be described as to its operations.

As shown in Figure 3, the memory decoding system generates internal 16-bit signals and external 8-bit signals including the memory request signals MREQ, the memory read/write signals R/W, the address signals $A_0$-$A_{19}$ and the data $D_0$ - $D_7$ through the microprocessor 17. The four uppermost address signals $A_{16}$ - $A_{19}$ of the addresses $A_0$ - $A_{19}$ are supplied to the NAND gate $G_2$ of the first selection signal generating section 18, and the output signals of the NAND gate $G_2$ are inputted into one of the input terminals of the OR gate $G_3$.

The other input terminal of the OR gate $G_3$ receives the memory request signal MREQ, and, after carrying out a computation in this state, the OR gate $G_3$ supplies a chip selecting signal $\overline{CS_0}$ to the ROM$_1$ of the memory section 16.

Further, of the address signals Ao-$A_{19}$ generated by the microprocessor 17, the two uppermost address signals $A_{18}$, $A_{19}$ are supplied to the two input terminals of the OR gate $G_1$ of the second selection signal generating section 20, and the three upper address signals $A_{15}$ -$A_{17}$ are inputted into the input terminal of the decoder 19 (3×8). Under this condition, the decoder 19 outputs chip selecting signals $\overline{CS_1}$ -$\overline{CS_4}$ to the respective RAMs (RAM$_1$ -RAM$_4$) of the memory section 16 upon receipt of the memory request signal MREQ of the microprocessor 17, the output signal of the OR gate $G_1$ , and the driving signal $B^+$ (supplied to turn on) which are used as the enabling signals. To describe it in more detail, when the logic values of the address signals $A_{16}$-$A_{19}$ are all "1", the output signals of the NAND gate $G_2$ of the first selection signal generating section 18 have the value of "0". Under this condition, if the memory signal MREQ is in active low state, the output signals of the OR gate $G_3$ have the logic value of "0". Accordingly, an active low signal as the chip selecting signal $\overline{CS_0}$ is supplied to the ROM$_1$ of the memory section 16, and then, it becomes possible for the microprocessor 17 to access the ROM$_1$ for the data.

Further, if the address signals $A_{18}$, $A_{19}$ and the memory request signal MREQ have the logic value of "0", and if the driving voltage B has the logic value of "1", the decoder 19 is placed in a chip enable state, so that the chip selecting signals $\overline{CS_1}$ -$\overline{CS_4}$ should be supplied to the memory section 16 after combining and mixing the address signals $A_{15}$ - $A_{17}$ which are the input signals. Under this condition, only one of the chip selecting signals $\overline{CS_1}$ -$\overline{CS_4}$ is placed in an active low state, and one of the RAMs (RAM$_1$ -RAM$_4$) is placed in a chip enable state. Accordingly, the microprocessor 17 can make the chip-enabled RAY access the required data. Consequently, depending on the values of the logics of the address signals $A_{18}$, $A_{19}$, only one of the RAMs (RAM$_1$ - RAM$_4$) and the ROM of the memory section is enabled. Further, if the read/write signals R/W of the microprocessor 17 is in a low state, the ROM$_1$ and the RAMs ( RAM$_1$ - RAM$_4$) is placed in a read enable state, while, if the read/write signals R/W are in a high state,

the ROM$_1$ and the RAMs (RAM$_1$ -RAM$_4$) are placed in an output enable state.

The present invention will bring the following effects.

First, the longitudinal address of the system is divided into a plurality of address regions in accordance with the uses of the ROM and a plurality of the RAMs (forming the memory section), and, this alleviates the load of the microprocessor. Therefore, the utilization of the memory section of the portable data terminal is maximized.

Second, the memory decoding system is constituted with the minimum number of the elements by utilizing the efficient memory map structure. Accordingly, not only the memory decoding system can be constituted into a compact type so as for it to be fit to the characteristics of the portable data terminal, but also the otherwise unnecessary squandering of the dc power source can be prevented.

**Claims**

1. A memory decoding system for a portable data terminal, comprising :

   a) a memory control means (17) for generating address signals, data signals, memory request signals and memory read/write signals, and for controlling said signalsin such a manner as to make it possible to read said data from a memory and to store said data into said memory ;
   b) a memory storing means (16) divided into a plurality of exclusive regions, and controlled in such a manner as to write and read for the specified uses through said memory control means (17);
   c) a first selection signal generating means (18) for generating memory selecting signals in order to select one of the memory regions of said memory storing means (16), by logic-combining the upper bits of said address signals ($A_{16}$-$A_{19}$) and memory request signals (MREQ) of said memory control means (17), wherein said first selection signal generating means (18) comprises : a NAND gate ($G_2$) for logic-combining the upper bits of said address signals ($A_{16}$-$A_{19}$); and an OR gate ($G_3$) for generating a signal in order to select said ROM of said memory storing means (16) by logic-combining the output signals of said NAND gate ($G_2$) and said memory request signals (MREQ) ;
   d) a second selection signal generating means (20) for generating memory selecting signals in order to select another memory region of said memory storing means (16), by logic-combining upper bits of said address signals, said memory request signals, lower bits of said address signals, and driving voltage signals, wherein said second selection signal generating means (20) comprises : an OR gate ($G_1$) for logic-combining the uppermost bits of the uppermost address signals ($A_{18}$-$A_{19}$); and a decoder (19) for logic-combining the output signals of said OR gate ($G_1$), said memory request signals (MREQ), said driving voltage signals, and said lower bits of said address signals.

2. The memory decoding system as claimed in claim 1, wherein said memory storing means (16) comprises a ROM for storing a system program, and a plurality of RAMs, and is divided into a ROM region, a system RAM region and user RAM regions.

## Patentansprüche

1. Speicherdecodierungssystem für eine tragbare Datenendstation, mit:

a) einer Speichersteuereinrichtung (17) zum Erzeugen von Adressensignalen, Datensignalen, Speicheranforderungssignalen und Speicher-Lese/Schreib-Signalen und zum Steuern der Signale auf eine Weise, daß die Daten aus einem Speicher ausgelesen und in dem Speicher abgelegt werden können;

b) einer Speicherablageeinrichtung (16), die in mehrere Exklusivbereiche unterteilt ist und so gesteuert wird, daß für die spezifizierten Anwendungen über die Speichersteuereinrichtung (17) eingeschrieben und ausgelesen wird,

c) einer ersten Wählsignalerzeugungseinrichtung (18) zum Erzeugen von Speicherwählsignalen, um durch logische Verknüpfung der höherwertigen Bits der Adressensignale (A16-A19) und Speicheranforderungssignale (MREQ) der Speichersteuereinrichtung (17) einen der Speicherbereiche der Speicherablageeinrichtung (16) auszuwählen, wobei die erste Wählsignalerzeugungseinrichtung (18) aufweist: ein NICHT-UND-Gatter ($G_2$) zur logischen Verknüpfung der höherwertigen Bits der Adressensignale (A16-A19) und ein ODER-Gatter ($G_3$) zum Erzeugen eines Signals, um durch logische Verknüpfung der Ausgangssignale des NICHT-UND-Gatters ($G_2$) und der Speicheranforderungssignale (MREQ) den Festwertspeicher (ROM) der Speicherablageeinrichtung (16) auszuwählen;

d) einer zweiten Wählsignalerzeugungseinrichtung (20) zum Erzeugen von Speicherwählsignalen, um durch logische Verknüpfung der höherwertigen Bits der Adressensignale, der Speicheranforderungssignale, der niedrigerwertigen Bits der Adressensignale und der Steuerspannungssignale einen anderen Speicherbereich der Speicherablageeinrichtung (16) auszuwählen, wobei die zweite Wählsignalerzeugungseinrichtung (20) aufweist: ein ODER-Gatter ($G_1$) zur logischen Verknüpfung der höchstwertigen Bits der obersten Adressensignale (A18, A19); und einen Decodierer (19) zur logischen Verknüpfung der Ausgangssignale des ODER-Gatters ($G_1$), der Speicheranforderungssignale (MREQ), der Steuerspannungssignale und der niedrigerwertigen Bits der Adressensignale.

2. Speicherdecodierungssystem nach Anspruch 1, wobei die Speicherablageeinrichtung (16) einen Festwertspeicher (ROM) zum Speichern eines Systemprogramms und mehrere Direktzugriffsspeicher (RAM) aufweist und in einen ROM-Bereich, einen RAM-Systembereich und RAM-Nutzerbereiche unterteilt ist.

## Revendications

1. Un système de décodage de mémoire pour terminal portable de données, comprenant:

a) un moyen de commande (17) de mémoire pour engendrer des signaux d'adresse, des signaux de données, des signaux de demande de mémoire et des signaux de lecture/écriture de mémoire, et pour commander lesdits signaux de manière à rendre possible une lecture desdites données dans une mémoire et un enregistrement desdites données dans ladite mémoire;

b) un moyen d'enregistrement (16) en mémoire divisé en une série de régions exclusives, et commandé de manière à écrire et lire pour les utilisations spécifiées par l'intermédiaire dudit moyen de commande (17) de mémoire,

c) un premier moyen générateur (18) de signaux de sélection pour engendrer des signaux de sélection de mémoire afin de sélectionner l'une des régions de mémoire dudit moyen d'enregistrement (16) en mémoire, en combinant logiquement les bits supérieurs desdits signaux (A16, A19) d'adresse et les signaux (MREQ) de demande de mémoire dudit moyen de commande (17) de mémoire,

ledit premier moyen générateur (18) de signaux de sélection comprenant: une porte NON-ET ou NAND ($G_2$) pour combiner logiquement les bits supérieurs desdits signaux (1A16, A19) d'adresse; et une porte OU ($G_3$) pour engendrer un signal afin de sélectionner ladite mémoire morte ou ROM dudit moyen d'enregistrement (16) en mémoire en combinant logiquement les signaux de sortie de ladite porte NON-ET ($G_2$) et lesdits signaux de demande (MREQ) de mémoire;

d) un deuxième moyen générateur (20) de signaux de sélection pour engendrer des signaux de selection de mémoire afin de sélectionner une autre région de mémoire dudit moyen d'enregistrement (16) en mémoire, en combinant logiquement des bits supérieurs desdits signaux d'adresse, lesdits signaux de demande de mémoire, des bits inférieurs desdits signaux d'adresse, et des signaux de tension d'excitation,

ledit deuxième moyen générateur de signaux de sélection comprenant: une porte OU ($G_1$) pour combiner logiquement les bits supérieurs des signaux supérieurs (A18, A19) d'adresse; et un décodeur (19) pour combiner logiquement les signaux de sortie de ladite porte OU ($G_1$), lesdits signaux de demande (MREQ) de mémoire, lesdits signaux de tension d'excitation, et lesdits bits inférieurs desdits signaux d'adresse.

2. Le système de décodage de mémoire selon la revendication 1, dans lequel ledit moyen d'enregistrement (16) en mémoire comprend une mémoire morte ou ROM pour enregistrer un programme de système, et une série de mémoires vives ou RAM, et est divisé en une région de ROM, une région de RAM du système et des régions de RAM d'utilisateur.

F I G. 1

# FIG.2

```
FFFFF ┌─────────────────────────┐
      │            a            │
      ├ ─ ─ ─ ─ ─ ─ ─ ─ ─ ─ ─ ─ ┤
      │            b            │
F0000 │                         │
EFFFF └─────────────────────────┘


40000 ┌─────────────────────────┐
3FFFF │                         │
      │            c            │
20000 │                         │
1FFFF ├─────────────────────────┤
      │            d1           │
10000 │                         │
0FFFF ├─────────────────────────┤
      │            d2           │
08000 │                         │
07FFF ├─────────────────────────┤
      │            d3           │
00000 └─────────────────────────┘
```

F I G. 3